# EUROPÄISCHE PATENTSCHRIFT

(11) **EP 1 660 250 B1**
(45) Veröffentlichungstag und Bekanntmachung des Hinweises auf die Patenterteilung: **01.08.2007**
(21) Anmeldenummer: 04786229.7
(22) Anmeldetag: 20.08.2004
(51) Int. Cl.: B21C 1/00, C22F 1/08, C22F 1/10, C22F 1/14

(54) **VERFAHREN ZUR HERSTELLUNG VON METALLISCHEN FLACHDRÄHTEN ODER BÄNDERN MIT WÜRFELTEXTUR**
METHOD FOR PRODUCING METALLIC FLAT WIRES OR STRIPS WITH A CUBIC TEXTURE
PROCEDE DE FABRICATION DE FILS PLATS OU DE BANDES METALLIQUES PRESENTANT UNE TEXTURE CUBIQUE

(30) Priorität: 25.08.2003 DE 10339867
(43) Veröffentlichungstag der Anmeldung: 31.05.2006
(73) Patentinhaber: Leibniz-Institut für Festkörper- und Werkstoffforschung Dresden e.V., 01069 Dresden (DE)
(72) Erfinder: EICKEMEYER, Jörg, 01279 Dresden (DE); SELBMANN, Dietmar, 01738 Colmnitz (DE); OPITZ, Ralph, 01108 Dresden (DE); HOLZAPFEL, Bernhard, 01731 Kreischa (DE); WENDROCK, Horst, 01561 Kleinthiemig (DE)
(74) Vertreter: Rauschenbach, Marion
(86) Internationale Anmeldenummer: PCT/EP2004/051853
(87) Internationale Veröffentlichungsnummer: WO 2005/023445

(56) Entgegenhaltungen:
- WO-A-00/58044
- WO-A-00/60132
- WO-A-03/024637
- DE-C- 3 634 242

## Beschreibung

### Anwendungsgebiet der Erfindung

Die Erfindung bezieht sich auf das Gebiet der Werkstoffwissenschaft und betrifft ein Verfahren zur Herstellung von metallischen Flachdrähten oder Bändern mit Würfeltextur (siehe z.B. WO 03/024637 A oder WO 00/58044 A), die beispielsweise als Unterlage für physikalisch-chemische Beschichtungen mit hochgradiger mikrostruktureller Ausrichtung einsetzbar sind. Die Textur dient dabei als Basis für ein kristallographisch orientiertes Aufwachsen der abgeschiedenen Schichten auf dem Substrat. Solche Unterlagen sind zum Beispiel als Substrate für metallische oder keramische Beschichtungen geeignet, wie sie auf dem Gebiet der Hochtemperatur-Supraleitung angewendet werden. Der Einsatz solcher Substratbändern für Schicht-Supraleiter kann in supraleitenden Magneten, Transformatoren, Motoren, Tomographen oder supraleitenden Strombahnen, bzw. Kabeln erfolgen. Darüber hinaus können solche texturierten Metallbänder als Magnetwerkstoffe angewendet werden, wie beispielsweise die hochpermeablen Nickel-Eisen-Legierungen.

### Stand der Technik

Bekannt ist, dass polykristalline Metalle mit kubisch-flächenzentriertem Gitter, wie Kupfer, Nickel, Gold und unter bestimmten Bedingungen auch Silber nach vorausgegangener starker Kaltumformung durch Walzen von Blechen oder flachen Bändern bei der nachfolgenden Rekristallisation eine ausgeprägte Textur mit Würfellage ausbilden können (G. Wassermann: Texturen metallischer Werkstoffe, Springer, Berlin, 1939; H. Hu u.a.: Trans. ASM 224(1962)96-105). Die grundlegenden Arbeiten (W. Köster: Z. Metallkde. 18(1926)112-116) und auch die weiter führenden Untersuchungen (R. D. Doherty u.a.: Mater. Sci. Eng. A257(1998)18-36) wurden mit Bandwalzen mit anschließender Glühbehandlung durchgeführt.

Auf diese Weise durch Walzen unter den Bedingungen des ebenen Deformationszustandes und anschließendes Glühen texturierte Metallbänder, insbesondere Nickel- und Silberbänder, werden heute auch als Unterlage für metallische Überzüge, keramische Pufferschichten und keramische Supraleiterschichten benutzt (A. Goyal u.a.: US Patent 5 741 377, Apr.21,1998). Die Eignung solcher Metallbänder als Substratwerkstoff hängt maßgeblich vom erreichbaren Grad der Texturierung sowie ihrer Qualität unmittelbar auf der Oberfläche ab.

Neben chemischen Legierungseinflüssen auf die Texturqualität ist die Ausbildung der Rekristallisations-Würfeltextur vor allem auch an spezifische mechanische, umformtechnische Voraussetzungen gekoppelt. Unabdingbar ist ein hoher Mindestumformgrad beim Kaltwalzen, wobei ein feinkörniges Ausgangsgefüge des Umformgutes vorteilhaft ist. Für Kupfer beträgt der Mindestumformgrad 82% (O. Dahl, F. Pawlek: Z. Metallkde. 28(1936)266-271). Um hochgradig zu texturieren werden allerdings wesentlich höhere Umformgrade aufgebracht, die zum Teil über 99% Dickenreduktion betragen. Diese umformtechnisch sehr aufwändige Herstellungstechnologie wird gegenwärtig in Kauf genommen, da alternative Techniken seit Jahrzehnten nicht gesehen werden. Andere Formgebungsverfahren als das Walzen spielen somit bei der Herstellung von Metallbändern mit Würfeltextur derzeit in der Praxis keine Rolle.

Kürzlich wurde allerdings nachgewiesen, dass auch die Umformung von Bandmaterial mittels Ziehverfahren bei der nachfolgenden Glühbehandlung zur Würfeltextur führen kann (J. Eickemeyer, D. Selbmann, R. Opitz, B. de Boer, B. Holzapfel, L. Schultz: 8. Sächsische Fachtagung Umformtechnik, 04.-05.12.2001, TU Bergakademie Freiberg/Sa., S. 99-106). Diese Verfahrensweise hat bisher noch keinen Eingang in die Praxis gefunden.

Eine allgemeingültige Theorie über die Wirkungen von Spannungs- und Deformationszuständen auf die Ausbildung der Umform- und Glühtexturen der Metalle, bzw. im besonderen des Nickels, Kupfers, Golds und Silbers gibt es nicht. Es ist deshalb nicht möglich, die Wirksamkeit eines Umformverfahrens auf die Ausbildung der Verformungs- und Glühtexturen sicher zu berechnen. Darüber hinaus beeinflussen auch die Reibungsbedingungen zwischen Umformgut und Umformwerkzeug die Texturformierung in Bändern, und insbesondere in dünnen Bändern, in bisher nicht vorhersagbarer Weise.

Mit dem wachsenden Interesse an weitgehend idealen Glühtexturen für die Anwendung von Bändern als sehr lange, quasi-einkristalline Substrate (supraleitende Schichtleiter) steht zugleich die Forderung nach einer möglichst perfekten Textur nicht nur im Bandinneren, sondern insbesondere auf der Oberfläche solcher Beschichtungsunterlagen. Aus diesem Grunde sind sämtliche für die Texturausbildung eventuell störenden Einflüsse kritisch zu bewerten und nach Möglichkeit abzuwenden. Nicht zuletzt gilt dies für die optimalen Verfahrensbedingungen bei der Werkstoffumformung, die bisher im Wesentlichen auf die Einflussgrößen beim Walzen von Bändern und Blechen begrenzt sind.

### Darlegung des Wesens der Erfindung

Der Erfindung liegt die Aufgabe zu Grunde, ein Verfahren zur Herstellung von metallischen Flachdrähten oder Bändern mit Würfeltextur anzugeben, mit dessen Hilfe die Erzeugnisse nach dem letzten Umformschritt und der abschließenden Glühbehandlung eine hochgradige Würfeltextur aufweisen.

Die Aufgabe wird durch die in den Ansprüchen angegebene Erfindung gelöst. Weiterbildungen sind Gegenstand der Unteransprüche.

Bei dem erfindungsgemäßen Verfahren zur Herstellung von metallischen Flachdrähten oder Bändern mit Würfeltextur wird ein Nickel-, Kupfer-, Gold- oder Silberbasiswerkstoff mittels eines Kaltziehverfahrens bei hochgradiger Umformung über mehrere Ziehstufen zu einem Draht mit einem im Wesentlichen kreisförmigen Querschnitt verarbeitet, wobei eine Gesamtquerschnittsreduktion ε_{g} ≥ 75 % oder eine logarithmische Formänderung ϕ_{g} ≥ 1,4 realisiert wird. Anschließend wird der Draht mittels weiterer Umform- und Glühverfahren zu einem metallischen Flachdraht oder einem Band mit Würfeltextur und definiert einstellbarer Breite weiterverarbeitet, wobei die definierte Breite aus dem Drahtquerschnitt und den Umformgraden der weiteren Umformschritte des Drahtes ermittelt und eingestellt wird.

Vorteilhafterweise wird das Kaltziehverfahren mit einer Gesamtquerschnittsreduktion von ε_{g} ≥ 90 % oder einer logarithmischen Formänderung von ϕ_{g} ≥ 2,3 realisiert.

Ebenfalls vorteilhafterweise wird das Kaltziehverfahren als Gleitziehen durch Ziehsteine mit Ziehwinkeln 2α = 2 ° - 20 ° realisiert, wobei Ziehwinkel von 2α ≤ 12 ° noch vorteilhafter sind.

Weiterhin vorteilhaft ist es, wenn das Kaltziehverfahren mit jeweils wechselnder Ziehrichtung , d.h. reversierend, durchgeführt wird.

Und ebenfalls von Vorteil ist es, wenn auf eine Zwischenbehandlung des Drahtes vor den weiteren Umform- und Glühverfahren verzichtet wird.

Das erfindungsgemäße Verfahren verwendet als Ausgangsstoff für die metallische Flachdraht- oder Band-Herstellung metallische Basiswerkstoffe, die nach einer Kaltumformung und sich daran anschließende Rekristallisation zur Ausbildung der Würfeltextur neigen. Hierzu zählen die metallischen Werkstoffe mit kubisch-flächenzentriertem Gitter, wie Nickel, Kupfer, Gold und unter besonderen Bedingungen auch Silber sowie ein Teil ihrer Legierungen.

Diese metallischen Basiswerkstoffe werden erfindungsgemäß durch ein hochgradiges Kaltziehen zu einem Drahtmaterial mit einem im Wesentlichen kreisförmigem Querschnitt verarbeitet. Diese Drähte werden im Weiteren durch Anwendung der an sich bekannten Verfahren des Walzziehens durch frei drehbare Rollen oder durch Ziehen durch parallel angeordnete Ziehbacken oder durch Walzen, zu einem metallischen Flachdraht oder einem metallischen Band verarbeitet, wobei die Würfeltextur während der darauf folgenden, an sich bekannten, abschließenden Rekristallisationsglühung herausgebildet wird.

Unter metallischen Flachdrähten sollen im Rahmen dieser Erfindung Erzeugnisse verstanden werden, die aus Drähten durch Kaltumformung hergestellt werden, wobei die Breite und Dicke maßgeblich durch den Ausgangsdrahtdurchmesser und den aufgebrachten Umformgrad bestimmt sind.

Unter metallischen Bändern sollen Erzeugnisse verstanden werden, die aus Vorprodukten durch Kaltumformung hergestellt werden, wobei die Bandbreite durch Längsteilen breiterer Produkte erhalten wird.

Das hochgradige Kaltziehen wird zunächst mittels Durchziehen der Ausgangsmaterialien durch Ziehsteine, wie sie bei der Drahtherstellung üblich sind, ausgeführt. Die nachfolgende Umformung kann durch Walzen zu Bändern oder durch Ziehen von Bändern mittels Rollenwerkzeuge oder Ziehbacken ausgeführt werden.
Das Kaltziehen als Gleitziehen durch Ziehsteine erfolgt vorteilhafterweise durch Ziehsteine mit Ziehwinkeln zwischen 2 ° und 20 °, besonders vorteilhafterweise mit Ziehwinkeln ≤ 12 °. Dabei kann das Kaltziehen des Drahtes in ein und derselben Richtung (unidirektional) oder vorteilhafterweise mit jeweils wechselnder Ziehrichtung (reversierend) durchgeführt werden.

Weiterhin sind mit dem erfindungsgemäßen Verfahren keine Zwischenbehandlungen des Drahtes nach dem Drahtziehen und vor dem weiteren Umformen zu metallischen Flachdrähten und metallischen Bändern erforderlich, was technologische Vorteile bringt.

Durch das erfindungsgemäße Verfahren durch Kaltziehen zu Draht und weiteres Umformen zu Flachdraht oder Band und abschließendes Glühen wird bei vergleichbaren Dickenreduktionen mindestens der relative Texturgrad der Würfellage erreicht, wie er bei der Anwendung des bisher benutzten Kaltwalzens und auch des Kaltziehens mittels Rollenwerkzeugen oder Ziehbacken der Fall ist. Das intensive Drahtziehen führt zu einem Gefügezustand, der für die Herausbildung der späteren Rekristallisations-Würfeltextur besonders günstig ist.

Der Vorteil des neuen Verfahrens besteht vor allem darin, dass durch die Einstellung definierter Drahtdurchmesser und die Einstellung des Gesamtumformgrades der nachfolgenden Umformschritte des Drahtes die Breite der fertigen metallischen Flachdrähte oder metallischen Bänder einstellbar wird, ohne dass das ansonsten notwendige Längsteilen von breiten Bändern erforderlich ist. Außerdem entfällt eine aufwändige Kantenbearbeitung. Dadurch werden in-der Fertigungsstrecke sowohl die Einrichtungen zum Längsteilen, als auch die zur Kantenbearbeitung eingespart. Zugleich arbeitet das Verfahren ohne Materialverluste, wie sie durch abgeschnittene Randstreifen zwangsläufig entstehen, und ohne Zerspanungsprodukte, wie sie bei der Kantenbearbeitung unvermeidbar sind. Dadurch entfallen technologische Schritte, die stets auch die Oberflächenqualität der empfindlichen Bänder beeinträchtigen können.

Obwohl das Verfahren des Drahtziehens ein altbekanntes Umformverfahren ist, ist sein Einfluss auf die Umform- und Glühtexturen in aus Drähten gefertigten metallischen Flachdrähten oder metallischen Bändern bisher nicht untersucht worden.

Für Spezialbehandlungen, wie der Erzielung einer hochgradigen Würfeltextur, zeigt sich in überraschender Weise der nicht nachteilige Einfluss des Drahtziehens auf die Fertigung von metallischen Flachdrähten oder metallischen Bändern mit Würfeltextur. Dies ist deshalb sehr überraschend, weil sich die Ziehtexturen als Fasertexturen grundsätzlich von den Walztexturen unterscheiden und eine positive Beeinflussung im Sinne der angestrebten Rekristallisations-Würfellage, die bekanntermaßen aus der Walztextur bestimmter kubisch-flächenzentrierter Metalle und deren Legierungen entsteht, nicht vermutet werden kann. Selbst der inhomogene Spannungs- und Deformationszustand, wie er beim Verarbeiten der runden Drähte zum flachen Draht oder Band über einen weiten Abmessungsbereich vorliegt, bringt unerwartet keine Nachteile für das Endprodukt mit Würfeltextur.

Für die Anwendung des erfindungsgemäßen Verfahrens auf die Herstellung von Substratbändern oder Bändern für magnetische Anwendungen ergibt sich damit die Möglichkeit, bei gleicher oder verbesserter Produktqualität technologisch effektiver zu fertigen. Es werden zwangsläufig Energie und Arbeitsaufwand sowie Kosten für spezielle Anlagen, wie sie zum Längsteilen und zum Kantenbearbeiten ansonsten nötig sind, gespart.

Die schmelzmetallurgische Herstellung der zu texturierenden Metalle und Legierungen erfolgt vorzugsweise durch Gießen in eine Kupferkokille. Auch eine pulvermetallurgische Herstellung über kalt- und heißisostatisches Pressen kann für das Ausgangsmaterial alternativ zur schmelzmetallurgischen Herstellung zweckmäßig sein.

Die metallurgisch hergestellten Guss- oder Presskörper können vor Beginn der nachfolgenden üblichen Warmumformung durch eine Homogenisierungsglühung ein vorteilhaftes Ausgangsgefüge erhalten sowie eine kontrollierte Einstellung der Korngröße für die abschließende starke Kaltumformung. Der Warmumformgrad, wie auch die Temperatur und Dauer der Glühung können leicht vom Fachmann unter dem Aspekt der guten Kaltumformbarkeit im weiteren Prozess optimiert werden. Die Glühatmosphäre für die Rekristallisation ist zweckmäßigerweise reduzierend oder inert. Die Glühtemperaturen und -zeiten tendieren mit zunehmendem Legierungsgehalt zu veränderten Werten und können ebenfalls unproblematisch vom Fachmann eingestellt werden.

Der Unterschied der erfindungsgemäßen Lösung zu anderen bekannten Lösungen besteht im Wesentlichen darin, dass als Ausgangsprodukt für die Flachdraht- oder Bandherstellung nunmehr auch ein Draht mit einem im Wesentlichen runden Querschnitt eingesetzt werden kann, ohne dass sich nachteilige Auswirkungen auf die Würfeltextur im abschließend herzustellenden Flachdraht oder Band ergeben. Dies ist nach dem bekannten Stand der Technik nicht zu erwarten gewesen.
Die Zieh- und Glühtexturen in Drähten sind ihrem Typ nach Fasertexturen und dementsprechend durch eine einzige Vorzugsrichtung, die Drahtachse, ausgezeichnet. Dass ein hochgradig gezogener Draht mit Fasertextur durch eine vergleichsweise geringe nachfolgende Flachumformung für die Ausbildung einer biaxialen Rekristallisations-Würfeltextur vorbereitet werden kann, ergab sich somit überraschend.

### Bester Weg zur Ausführung der Erfindung

Die Erfindung ist nachstehend anhand von Beispielen näher erläutert.

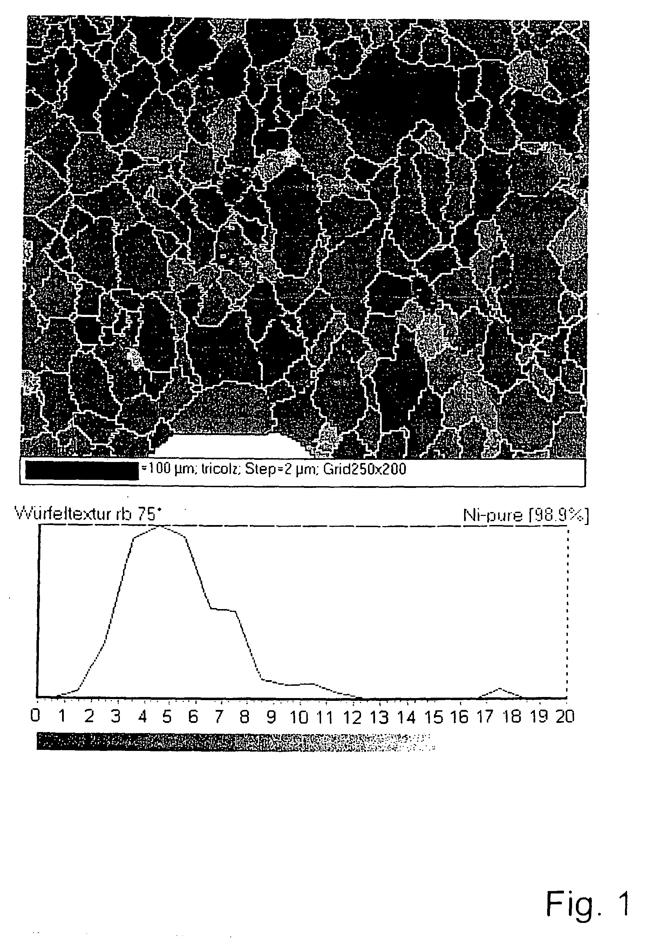

Dabei zeigt
- Fig. 1:: eine Gefügeaufnahme mittels EBSD und Texturgrad von 82 µm dickem Nickel-Eisen-Band (Ni53Fe47), das durch unidirektionales Walzziehen vom Durchmesser 1,25mm (ε = 87,9%) gefertigt wurde, nachdem der Ausgangsdraht von ∅20mm an ∅5mm(ε = 93,75%) gezogen wurde und nach einer Zwischenglühung an ∅1,25mm(ε = 93,75%) weiter gezogen wurde.

### Beispiel 1

Ein runder Stab der Legierung Ni53-Fe47 wird herkömmlich im Stab- oder Drahtzug vom Durchmesser 20 mm in mehreren Stufen zu einem Draht mit einem im wesentlichen runden Querschnitt von 5 mm Durchmesser gezogen (1. Gesamtabnahme von ε_{g} = 93,75%). Nach einer Rekristallisationsglühung bei 850°C wird weiter kalt gezogen auf einen Durchmesser von 1,25 mm (2. Gesamtabnahme von ε_{g} = 93,75%). Dieser Draht wird anschließend durch unidirektionales Walzziehen mit einer Querschnittsabnahme von ε_{g} = 87,4 % zu einem Flachdraht mit einer Breite von 1,89 mm und einer Dicke von 82 µm weiterverarbeitet. Die Texturglühung bei 1100°C über 60 Minuten ergibt eine hochgradige Rekristallisations-Würfeltextur, die im Gefüge einen Anteil von 94,3% ausmacht (Fig. 1), wobei 93,1 % aller Korngrenzen Kleinwinkelkorngrenzen mit einer Missorientierung < 10° sind (weiß in Fig. 1). Eine solche Texturqualität wird bei konventioneller Arbeitsweise der durchgängigen Bandumformung von Flacherzeugnissen erst nach Banddickenreduktionen von mehr als ε_{g} = 99% erzielt. Eine weitere Bearbeitung des entstandenen Flachdrahtes ist nicht erforderlich.

### Beispiel 2

Ein runder Stab der Legierung Ni53-Fe47 wird herkömmlich im Stab- oder Drahtzug vom Durchmesser 20mm in mehreren Stufen zu einem Draht mit einem im wesentlichen runden Querschnitt von 5 mm Durchmesser gezogen (1. Gesamtabnahme von ε_{g} = 93,75%). Nach einer Rekristallisationsglühung bei 850°C wird weiter kalt gezogen auf einen Durchmesser von 1,25 mm (2. Gesamtabnahme von ε_{g} = 93,75%). Dieser Draht wird anschließend durch reversierendes Walzziehen mit einer Querschnittsabnahme von ε_{g} = 87,9 % zu einem Band mit einer Breite von 1.86 mm und einer Dicke von 77 µm weiterverarbeitet. Die Texturglühung bei 1100°C über 60 Minuten ergibt eine hochgradige Rekristallisations-Würfeltextur, die im Gefüge einen Anteil von 91,3% ausmacht, wobei 92,8% aller Korngrenzen Kleinwinkelkorngrenzen (Missorientierung < 10°) sind. Eine solche Texturqualität wird bei konventioneller Arbeitsweise der durchgängigen Bandumformung von Flacherzeugnissen erst nach Banddickenreduktionen von mehr als ε_{g} = 99% erzielt. Eine weitere Bearbeitung des entstandenen Flachdrahtes ist nicht erforderlich.

### Beispiel 3

Ein runder Stab der Legierung Ni53-Fe47 wird herkömmlich im Stab- oder Drahtzug vom Durchmesser 20mm in mehreren Stufen zu einem Draht mit einem im wesentlichen runden Querschnitt von 1,25 mm Durchmesser gezogen (1. Gesamtabnahme von ε_{g} = 99,6%). Dieser Draht wird anschließend durch reversierendes Walzziehen mit einer Querschnittsabnahme von ε_{g} = 87,9 % zu einem Band mit einer Breite von 1,83 mm und einer Dicke von 80 µm weiterverarbeitet. Die Texturglühung bei 1100°C über 60 Minuten ergibt eine hochgradige Rekristallisations-Würfeltextur, die im Gefüge einen Anteil von 91,6% ausmacht, wobei 83,6% aller Korngrenzen Kleinwinkelkorngrenzen (Missorientierung < 10°) sind. Eine weitere Bearbeitung des entstandenen Bandes ist nicht erforderlich.

### Beispiel 4

Ein runder Stab der Legierung Ni53-Fe47 wird herkömmlich im Stab- oder Drahtzug vom Durchmesser 20mm in mehreren Stufen zu einem Draht mit einem im wesentlichen runden Querschnitt von 5 mm Durchmesser gezogen (1. Gesamtabnahme von ε_{g} = 93,75%). Nach einer Rekristallisationsglühung bei 850°C wird weiter kalt gezogen auf einen Durchmesser von 1,25 mm (2. Gesamtabnahme von ε_{g} = 93,75%). Dieser Draht wird anschließend durch reversierendes Walzziehen mit einer Querschnittsabnahme von ε_{g} = 82,2 % zu einem Band mit einer Breite von und einer Dicke von 97µm weiterverarbeitet. Die Texturglühung bei 1100°C über 60 Minuten ergibt eine hochgradige Rekristallisations-Würfeltextur, die im Gefüge einen Anteil von 82,9% ausmacht, wobei 61,9% aller Korngrenzen Kleinwinkelkorngrenzen (Missorientierung < 10°) sind. Eine weitere Bearbeitung des entstandenen Bandes ist nicht erforderlich.

### Beispiel 5

Ein Nickeldraht mit einem Legierungsgehalt von 5 Atom-% Wolfram wird von einem Ausgangsdurchmesser von 5mm in mehreren Stufen auf einen Durchmesser von 1 mm gezogen (ε_{g} = 96%). Danach wird der Draht ohne Zwischenbehandlung zu einem Flachdraht mit den Endabmessung von 1,9 mm Breite und 60 µm Dicke kalt gewalzt. Der Flachdraht wird abschließend einer Wärmebehandlung bei 1100°C über 1 Stunde unterzogen und bildet dabei eine scharfe Würfeltextur aus, wie sie für Unterlagen zur Beschichtung mit epitaktisch aufwachsenden Schichten verwendet werden.

## Patentansprüche

1. Verfahren zur Herstellung von metallischen Flachdrähten oder Bändern mit Würfeltextur, bei dem ein Nickel-, Kupfer-, Gold- oder Silberbasiswerkstoff mittels eines Kaltziehverfahrens bei hochgradiger Umformung über mehrere Ziehstufen zu einem Draht mit einem im Wesentlichen kreisförmigen Querschnitt verarbeitet wird, wobei eine Gesamtquerschnittsreduktion ε_{g} ≥ 75 % oder eine logarithmische Formänderung ϕ_{g} ≥ 1,4 realisiert wird, und anschließend der Draht mittels weiterer Umform- und Glühverfahren zu einem Flachdraht oder Band mit Würfeltextur und definiert einstellbarer Breite weiterverarbeitet wird, wobei die definierte Breite aus dem Drahtquerschnitt und den Umformgraden der weiteren Umformschritte des Drahtes ermittelt und eingestellt wird.

2. Verfahren nach Anspruch 1, bei dem das Kaltziehverfahren mit einer Gesamtquerschnittsreduktion von ε_{g} ≥ 90 % oder einer logarithmischen Formänderung von ϕ_{g} ≥ 2,3 realisiert wird.

3. Verfahren nach Anspruch 1, bei dem das Kaltziehverfahren als Gleitziehen durch Ziehsteine mit Ziehwinkeln 2α = 2° - 20° realisiert wird.

4. Verfahren nach Anspruch 3, bei dem das Kaltziehen mit Ziehwinkeln 2α ≤ 12 ° realisiert wird.

5. Verfahren nach Anspruch 1, bei dem das Kaltziehverfahren mit jeweils wechselnder Ziehrichtung, d.h. reversierend, durchgeführt wird.

6. Verfahren nach Anspruch 1, bei dem auf eine Zwischenbehandlung des Drahtes vor den weiteren Umform- und Glühverfahren verzichtet wird.

## Claims

1. Process for producing metallic flat wires or strips with a cubic texture, in which a nickel-, copper-, gold- or silver-based material is processed by means of a cold-drawing process with a high degree of deformation over a plurality of drawing stages to form a wire with a substantially circular cross section, producing a total reduction in cross section ε_{g} ≥ 75% or a true strain ϕ_{g} ≥ 1.4, and then the wire is processed further, by means of further deformation and annealing processes, to form a flat wire or strip with a cubic texture and a width that can be set in a defined way, the defined width being determined and set from the wire cross section and the degrees of deformation of the further wire deformation steps.

2. Process according to Claim 1, in which the cold-drawing process is carried out with a total reduction in cross section of ε_{g} ≥ 90% or a true strain of (ϕ_{g} ≥ 2.3.

3. Process according to Claim 1, in which the cold-drawing process is realized as a drawing operation through drawing dies with drawing angles 2α = 2°-20°.

4. Process according to Claim 3, in which the cold-drawing is realized using drawing angles 2α ≤ 12°.

5. Process according to Claim 1, in which the cold-drawing process is carried out using in each case an alternating drawing direction, i.e. as a reversing operation.

6. Process according to Claim 1, in which no intermediate treatment of the wire is carried out prior to the further deformation and annealing processes.

## Revendications

1. Procédé de fabrication de fils plats ou de bandes métalliques à texture cubique, dans lequel on traite un matériau à base de nickel, de cuivre, d'or ou d'argent par un procédé d'étirage à froid à haut degré de déformation et en plusieurs étapes d'étirage pour obtenir un fil de section transversale essentiellement circulaire, la réduction totale de section transversale ε_{g} ≥ 75 % ou la modification logarithmique de forme ϕ_{g} ≥ 1,4 étant réalisée, le fil étant ensuite transformé au moyen d'autres opérations de déformation et de recuit en un fil plat ou une bande à texture cubique dont la largeur peut être réglée de manière définie, la largeur définie étant déterminée et établie à partir de la section transversale du fil et des degrés de déformation des autres étapes de déformation du fil.

2. Procédé selon la revendication 1, dans lequel l'opération d'étirage à froid est réalisée à une réduction globale de la section transversale ε_{g} ≥ 90 % ou une modification logarithmique de forme ϕ_{g} ≥ 2,3.

3. Procédé selon la revendication 1, dans lequel l'opération d'étirage à froid est réalisée sous la forme d'un étirage coulissant par des blocs d'étirage dont l'angle d'étirage 2 α = 2° - 20°.

4. Procédé selon la revendication 3, dans lequel l'étirage à froid est réalisé à des angles d'étirage 2 α ≤ 12°.

5. Procédé selon la revendication 1, dans lequel l'opération d'étirage à froid est réalisée dans les directions d'étirage alternées, c'est-à-dire inversées.

6. Procédé selon la revendication 1, dans lequel aucun traitement intermédiaire n'est réalisé sur le fil avant les autres opérations de déformation et de recuit.
